# EUROPEAN PATENT APPLICATION

(11) **EP 3 907 456 A1**
(43) Date of publication of application: **10.11.2021**
(21) Application number: 19913546.8
(22) Date of filing: 17.12.2019
(51) Int. Cl.: F28D 15/02

(54) **PHASE CHANGE HEAT RADIATING DEVICE**

(30) Priority: 29.01.2019 CN 201910086875
(71) Applicant: Smarth Technology Ltd., Zhuzhou, Hunan 412000 (CN)
(72) Inventor: LI, Chun, Zhuzhou, Hunan 412000 (CN); HU, Guangfan, Zhuzhou, Hunan 412000 (CN); YAO, Chunhong, Zhuzhou, Hunan 412000 (CN); MA, Qiucheng, Zhuzhou, Hunan 412000 (CN)
(74) Representative: Groth & Co. KB
(86) International application number: PCT/CN2019/125969
(87) International publication number: WO 2020/155900

(57) **Abstract**

The present invention discloses a phase-change heat dissipation device comprising a phase-change assembly internally provided with a phase-change heat exchange medium, and the phase-change heat exchange medium provided in the phase-change assembly is configured such that, in an operating state of the phase-change heat dissipation device, an air pressure within the phase-change assembly is greater than 0.15 MPa. When the phase-change heat dissipation device of the present invention works in a working temperature range of 30-80°C, the internal pressure is far greater than the standard atmospheric pressure, the internal of the phase-change heat dissipation device is in a positive-pressure non-vacuum environment, the heat flux density of the heat source is high, the absolute pressure in the evaporator part of the phase-change assembly is high, the relative pressure difference between different parts of the phase-change assembly under the same temperature difference condition is large, and the pressure difference can drive more phase-change medium. Therefore, the heat exchange capacity is enhanced, the fluidity of the internal phase-change heat exchange medium is improved, which improves the heat flux density of heat transfer and makes it easier to achieve efficient heat dissipation.

## Description

### Technical field

The present invention pertains to the technical field of phase-change heat dissipation devices, and particularly related to a phase-change heat dissipation device for electronic components.

### Background

Phase-change heat dissipation is an efficient heat dissipation mode, the principle thereof is that a phase-change heat exchange medium is used for boiling, gasifying and absorbing heat at a certain temperature, and then the gasified gas is condensed and liquefied at other positions to release heat, so that heat transfer is achieved. Phase-change heat dissipation is widely used because of its good heat transfer effect.

At present, a phase-change heat dissipation device generally adopts heat pipes for phase-change heat dissipation, and as compared with other traditional heat dissipation modes, the heat pipes for heat dissipation are high in heat transfer efficiency and good in heat dissipation effect. A common heat-pipe heat dissipation device is mainly composed of three parts, namely heat pipes, heat radiating fins and a heat conduction base. Wherein the heat pipes are used as a phase-change assembly for transferring heat in a phase-change mode, the heat conduction base connects the heating source with the heat dissipation device, the heat source transfers heat to the heat pipes through the heat conduction base, and the heat radiating fins transfer heat of the heat pipes and a phase-change heat exchange medium in the heat pipes to the outside. One end (evaporator part) of each of the heat pipes is embedded in or welded on the heat conduction base, and the other end (condenser part) of each of the heat pipes is connected with the heat radiating fins.

For the current common phase-change heat dissipation device, in order to realize the evaporation of a phase-change heat exchange medium at a proper temperature, most of the phase-change heat dissipation devices adopt a vacuum pumping mode to reduce the boiling point of the phase-change heat exchange medium. A traditional heat pipe adopts deionized water or ethanol as a working medium, which can only be vaporized at a working point by maintaining a certain negative pressure.

The heat pipe is tubular, the number of heat pipes suitable for being configured for a heat-pipe heat dissipation device is very limited, and the direct contact area between the heat pipes and a heat source is not large, so that, when heat is transferred from the heat source to a phase-change assembly (the heat pipes), great obstacles exist, the heat transfer efficiency is not high, the heat dissipation performance is severely limited, and local high temperature of the base can be caused. In addition, the heat dissipation mode of the heat pipe is one-dimensional, heat is conducted in a linear mode, the heat dissipation capacity and the heat dissipation effect of the heat pipe are not optimal, the cost for processing the heat-pipe heat dissipation device is high, and for most phase-change heat dissipation devices, most of the heat pipes work in an internal vacuum environment, which limits the flow of the internal phase-change heat exchange medium, and impedes heat dissipation.

In addition, most of the existing heat pipe shells are made of red copper, and most of the bases are made of aluminum alloy, and low-temperature tin brazing or cementing is usually adopted to fill the gaps after the heat pipes and the base are formed, therefore, a certain thermal resistance is generated, not good for heat transfer, and the disadvantages of low-temperature tin brazing include that: before welding, the heat dissipation device must be subjected to surface treatment such as integral nickel plating or copper plating, the processes of welding and surface treatment are of high cost and might pollute the environment; it is difficult for the brazing to ensure that the interface between the heat pipes and the aluminum alloy base is well filled and there is no remaining local gap, and due to the fact that the heat pipes are located below the power device and the heat flux density is large, any gap therein will lead to local temperature rise of the heat source device, resulting in damage to the device. Moreover, the processing cost of the heat-pipe heat dissipation device is high, and it is not friendly to the environment.

Therefore, the traditional phase-change heat dissipation devices have the problems of large heat transfer thermal resistance, non-uniform heat transfer, high production cost, and low heat exchange efficiency, etc.

### Summary of the invention

In order to solve the problems in the prior art as described above, the present invention provides a phase-change heat dissipation device for an electronic device so as to improve the heat transfer efficiency for promotion of fast dissipation of heat.

In order to achieve the above objective, the specific technical scheme of the phase-change heat dissipation device of the present invention for an electronic device is as follows:
A phase-change heat dissipation device comprises a phase-change assembly internally provided with a phase-change heat exchange medium, wherein the phase-change heat exchange medium provided in the phase-change assembly is configured such that, in an operating state of the phase-change heat dissipation device, the air pressure in the phase-change assembly is greater than 0.15 MPa.

Furthermore, the phase-change heat exchange medium provided in the phase-change assembly is any one or more of R134a, R142b, R114, R124, R1233Zd(E), R1234Ze(Z), R1234Ze(E), R600a, RC318, RE245cb2, R22, R32, R407C and R410A.

Furthermore, the phase-change assembly comprises an evaporator part and a condenser part, an evaporation chamber is formed in the evaporator part, a condensation chamber is formed in the condenser part, the evaporation chamber is communicated with the condensation chamber, and the phase-change heat exchange medium in the evaporation chamber is configured to absorb heat from a heating source and transfer the heat to the condensation chamber, and the condensation chamber is configured to radiate heat outwards, so as to cool the heat source.

Furthermore, the evaporation chamber is a planar or curved chamber.

Furthermore, the condenser part comprises a plurality of condensation support plates, and the condensation chamber comprises a planar chamber correspondingly arranged inside each of the condensation support plates; or the condenser part comprises a plurality of condensation branch pipes, and the condensation chamber comprises a cylindrical chamber correspondingly arranged inside each of the condensation branch pipes; or the condenser part comprises a plurality of condensation conical pipes, and the condensation chamber comprises a conical chamber correspondingly arranged inside each of the condensation conical pipes.

Furthermore, the condenser part is connected to the evaporator part directly or through a pipeline.

Furthermore, the inner wall of the condenser part is provided with a condensation enhancement structure, and the outer wall of the condenser part is provided with fins or ribs for increasing the condensation area.

Furthermore, a plurality of ribs, bumps or fins are arranged inside the evaporator part and condenser part to increase the pressure bearing capability.

Furthermore, the outer wall of the evaporator part is in contact with the heat source.

Furthermore, the outer surface of the evaporator part is provided with a contact heat absorption surface, the heating source is provided with a heat source surface, the contact heat absorption surface of the evaporator part is in contact with the heat source surface of the heating source, and both the heat source surface and the contact heat absorption surface are planar.

The phase-change heat dissipation device of the present invention has the following advantages:
1) The evaporator part of the phase-change assembly is in direct contact with a heat source, the evaporator part can be in sufficient contact with the heat source, the heat transfer area is large, the heat transfer effect is good, when the heat flux density of the heat source is large, the phase-change medium in direct contact with the bottom of the evaporation chamber is gasified, and local pressures rise, so that pressure difference is formed between the part of the evaporation chamber with the highest heat flux density in contact with the heat source and other parts thereof, a rapid heat diffusion of the evaporator part of the phase-change assembly can be achieved, and the temperature difference throughout the evaporator part would be very small.
2) the phase-change assembly is of a three-dimensional heat dissipation structure, and after the phase-change heat exchange medium is vaporized, the phase-change heat transfer medium can rapidly diffuse to any low-pressure part of the phase-change assembly, so that the temperature of the phase-change assembly is uniform, the heat transfer efficiency is high, and the heat transfer is uniform.
3) When the phase-change heat dissipation device works in a working temperature range of 30-80°C, the internal pressure is far greater than the standard atmospheric pressure, and the internal of the phase-change heat dissipation device is in a positive-pressure non-vacuum environment The heat flux density of the heat source is high, the absolute pressure in the evaporator part of the phase-change assembly is high, the relative pressure difference between different parts of the phase-change device under the same temperature difference condition is large, and the pressure difference can drive more phase-change medium, so that the heat exchange capacity is enhanced, the fluidity of the internal phase-change heat exchange medium is improved, which improves the heat flux density of heat transfer and makes it easier to achieve efficient heat dissipation.
4) When the phase-change heat dissipation device works, the evaporator part and the condenser part need to bear high pressure because of the large internal absolute pressure. Thus multiple ribs, bumps or fins are provided inside the evaporator part and the condenser part to increase the pressure bearing capability.
5) A structure for enhancing boiling and evaporation for heat exchange is brazed or sintered inside the phase-change assembly, thereby, the phase-change heat exchange medium can perform boiling heat exchange more efficiently, the heat diffusion is more uniform and rapid, and the heat transfer is also more efficient due to the increase of the heat exchange area.

In addition, the manufacturing of the phase-change heat dissipation device of the present invention does not need surface treatment processes such as copper plating and nickel plating, the phase-change structure and the cooling fins of the heat dissipation device are directly welded into a whole by high-temperature brazing, a heating source (such as a power device CPU) makes contact with the phase-change heat dissipation device, then low-temperature tin soldering is applied to avoid gaps, and thus the heat transfer limit of the phase-change heat dissipation device of the present invention is remarkably increased (far greater than 200W).

The present invention can be applied to power electronic components such as chips, resistors, capacitors, inductors, storage media, light sources and battery packs for heat dissipation.

### Brief description of the drawings

Fig. 1a is a perspective view of a first embodiment of the phase-change heat dissipation device of the present invention, wherein a plurality of condensation support plates are not in communication;
Fig. 1b is a cross-sectional view of the phase-change heat dissipation device of Fig.1a, wherein a plurality of condensation support plates are intercommunicated through a condensation top plate;
Fig. 2 is a perspective view of a second embodiment of the phase-change heat dissipation device of the present invention;
Fig. 3a is a perspective view of a third embodiment of the phase-change heat dissipation device of the present invention;
Fig. 3b is a cross-sectional view of the phase-change heat dissipation device of Fig. 3a;
Fig. 4a is a perspective view of a fourth embodiment of the phase-change heat dissipation device of the present invention;
Fig. 4b is a cross-sectional view of the phase-change heat dissipation device of Fig. 4a;
Fig. 5a is a perspective view of a fifth embodiment of the phase-change heat dissipation device of the present invention. In this device, the evaporator part and the condenser part are arranged separately and connected to each other through pipes, the evaporator part has a rectangular hollow chamber, while the condenser part has several condensation support plates;
Fig. 5b is a cross-sectional view of the phase-change heat dissipation device of Fig. 5a;
Fig. 6a is a perspective view of a sixth embodiment of the phase-change heat dissipation device of the present invention. In this device, the evaporator part and the condenser part are arranged separately and connected to each other through pipes, the evaporator part has a rectangular hollow chamber, while the condenser part has several condensation branch pipes, with multiple cylindrical chambers inside the condensation branch pipes;
Fig. 6b is a cross-sectional view of the phase-change heat spreader of Fig. 6a;
Figures 7-8 show schematic diagrams of the flow of the phase-change heat exchange medium in the phase-change assembly of the present invention;
Figs. 9-10 show schematic diagrams of heat exchange enhancement structures on the phase-change heat dissipation device.

### Detailed description of embodiments

In order to better understand the object, the structure and the function of the present invention, the phase-change heat dissipation device of the present invention is described in further details below in conjunction with the accompanying drawings.

The relevant terms of the present invention are defined as follows:
Boiling heat transfer refers to a heat transfer process wherein heat is transferred to liquid from a wall surface to enable the liquid to be boiled and vaporized.

Vaporization core is defined as a carrier for starting liquid boiling.

Thermal conductivity: it is defined as that, when two parallel planes with a distance of 1 meter and an area of 1 square meter each are taken perpendicular to the direction of heat conduction inside an object, and if the temperatures of the two planes differ by 1 K, the amount of heat conducted from one plane to the other plane in 1 second is defined as the thermal conductivity of the substance in Watt *m⁻¹*K⁻¹ (W·m⁻¹·K⁻¹).

Thermal resistance: it is defined as the ratio between the temperature difference across an object and the power of a heat source in Kelvin per Watt (K/W) or degrees Celsius per Watt (°C/W) when heat is transferred across the object.

The heat transfer coefficient, which is the amount of heat transferred through a unit area per unit time in watts per square meter per degree (W/m²·K, where K can be replaced by °C) under conditions of stable heat transfer with an air temperature difference of 1 degree (K or °C) between two sides of a building envelope, reflects the intensity of the heat transfer process.

Heat flux density: the amount of heat transferred through a unit area in a unit time is defined as the heat flux density, q = Q/(S*t). here, Q is the amount of heat, t is the time, S is the cross-sectional area, and the unit of heat flux density is J/(m²·s).

Excessive boiling: when the heat flux density is increased, a large amount of steam sprays from the vaporization core, which forms a steam column, and the liquid supply to the heat transfer surface is hindered by the steam flow, so that the liquid is dried on the heat transfer surface in a short time, which causes the temperature of the heat transfer surface to be rapidly increased.

Positive pressure: when the temperature of the contact part between the heat dissipation device and the heat source is stable, the pressure in the phase-change assembly of the heat dissipation device being more than 1.5 times of the standard atmospheric pressure (more than 0.15 MPa) is defined as positive pressure.

Micro-positive pressure: when the temperature of the contact part between the heat dissipation device and the heat source is stable, the pressure in the phase-change assembly of the heat dissipation device being between 0.1 MPa and 0.15 MPa is defined as micro-positive pressure. For example, when ethanol or the like is used as the phase-change heat exchange medium, the air pressure in the phase-change assembly is micro-positive pressure during working.

Negative pressure: when the temperature of the contact part between the heat dissipation device and the heat source is stable, the pressure in the phase-change assembly of the heat dissipation device being smaller than 0.1 MPa is defined as negative pressure. For example, when water is adopted as the phase-change heat exchange medium, the pressure in the phase-change assembly must be negative pressure during working, otherwise, the phase-change heat exchange medium cannot start functioning, and the heat dissipation device fails.

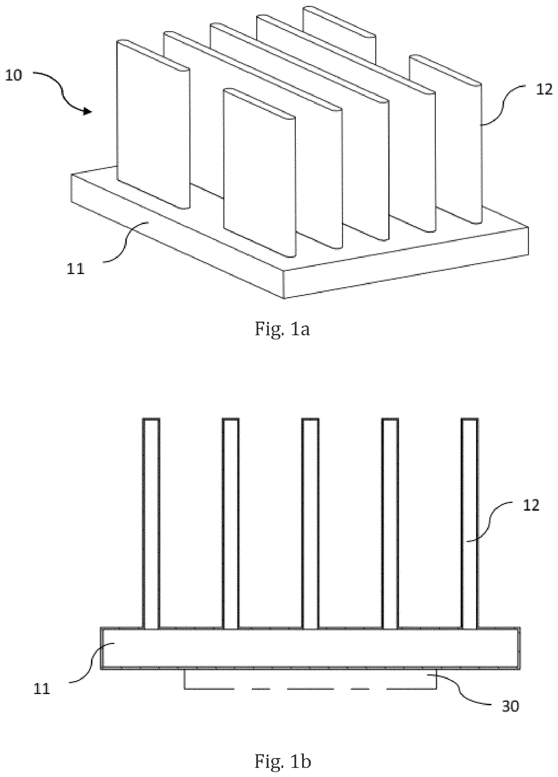

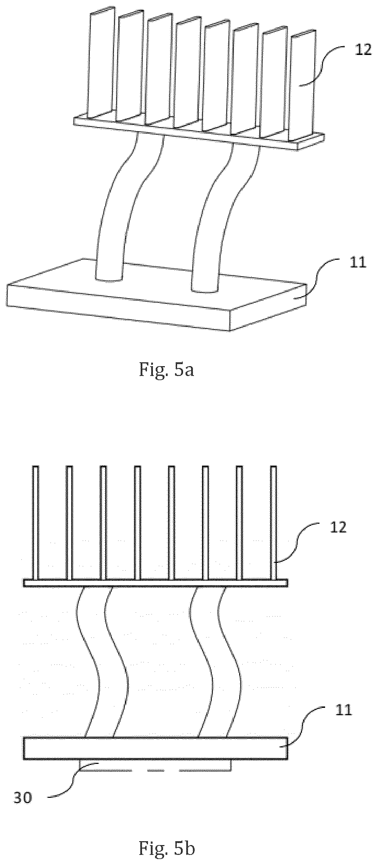

As shown in figures 1a-6b, the phase-change heat dissipation device 10 comprises an evaporator part 11, a condenser part 12 and a phase-change heat exchange medium 20 arranged in the evaporator part 11 or the condenser part 12, and the evaporator part 11 and the condenser part 12 jointly form a three-dimensional heat exchange structure. When the phase-change heat dissipation device 10 is in a working state, the working pressure in the phase-change heat dissipation device 10 is higher than 0.15 MPa, and the phase-change heat dissipation device 10 is in a positive pressure state. Wherein the evaporator part 11 and the condenser part 12 can be directly connected together (shown in Figs. 1a-4b), and the evaporator part 11 and the condenser part 12 can also be of a separated structure (shown in Figs. 5a-6b) connected together through a pipeline.

In the embodiment shown in Figures 5a-6b, the condenser 12 may be placed horizontally or vertically, with the configuration and placement orientation being changed according to the structural design of the system in which the CPU board is placed. The heating source 30 is directly installed on the evaporator part 11 of the phase-change assembly, heat is directly transferred to the phase-change heat exchange medium 20 through the thin wall of the evaporator part 11, the phase-change heat exchange medium 20 absorbs heat to generate phase change, so that pressure difference is generated between the evaporator part 11 and the condenser part 12 in the phase-change heat dissipation device 10, and therefore the phase-change heat exchange medium 20 is driven to flow towards the condenser part 12. After the phase-change medium is condensed in the condenser part 12, the phase-change medium returns to the evaporator part 11 by gravity or capillary force, so as to form a circulation.

As shown in figures 1a-1b, the phase-change heat dissipation device 10 comprises a phase-change assembly, the phase-change assembly is of a closed structure with a chamber inside, the phase-change assembly is internally provided with a phase-change heat exchange medium 20, the inner chamber of the phase-change assembly is of a fully-communicated structure, and the phase-change heat exchange medium 20 can circularly flow in the whole inner chamber of the phase-change assembly.

The phase-change assembly is provided with an evaporator part 11 and a condenser part 12, an evaporation chamber is formed in the evaporator part 11, a condensation chamber is formed in the condenser part 12, the evaporation chamber of the evaporator part 11 is communicated with the condensation chamber of the condenser part 12, the evaporation chamber and the condensation chamber form an inner chamber of the phase-change assembly, and the condenser part 12 is connected with cooling fins. The phase-change heat exchange medium 20 in the evaporation chamber absorbs heat from the heat source 30 and then is vaporized and flows into the condensation chamber to be cooled and liquefied, and the condensation chamber radiates heat outwards through the cooling fins. Therefore, the phase-change heat dissipation device 10 can transfer heat of the heat source 30 to air or other gaseous cooling media to achieve the effect of heat dissipation and cooling of the heat source.

The evaporator part 11 of the phase-change assembly is a planar plate-shaped body or a curved plate-shaped body with a chamber inside, a planar evaporation chamber or a curved-surface-shaped evaporation chamber is formed inside the evaporator part 11, and the planar chamber or the curved-surface-shaped chamber inside the evaporator part 11 is communicated with the condensation chamber inside the condenser part 12.

The condenser part 12 comprises a plurality of condensation support plates with chambers inside, the interiors of the condensation support plates are planar condensation chambers, the plurality of condensation support plates are connected to the evaporator part 11, and the planar condensation chambers inside the condensation support plates are communicated with the planar evaporation chamber or the curved evaporation chamber inside the evaporator part 11. The condensation support plates are preferably arranged in parallel in rows, the condensation support plates are perpendicularly connected to the evaporator part 11, the outer sides of the condensation support plates are connected with cooling fins, and the heat in the condensation support plates is radiated to the outside through the cooling fins. The evaporator part 11 is not limited to be of a plate-shaped body structure, and can also be of other cylindrical structures as long as the lower bottom surface thereof is planar.

Furthermore, a condensation enhancement structure is arranged on the inner wall of the condenser part 12, the condensation enhancement structure can be capillary structures distributed on the inner wall of the condenser part 12, the capillary structures are kidney-shaped columnar or cylindrical or conical structures, and the capillary structures have a capillary effect, so that the vaporized phase-change heat exchange medium 20 can flow along the condensation chamber more quickly and uniformly, and the condensed phase-change heat exchange medium 20 can also be quickly refluxed to the evaporation chamber. In addition, the heat exchange area of the condensation chamber can be increased by the capillary structures, and the heat transfer speed is increased.

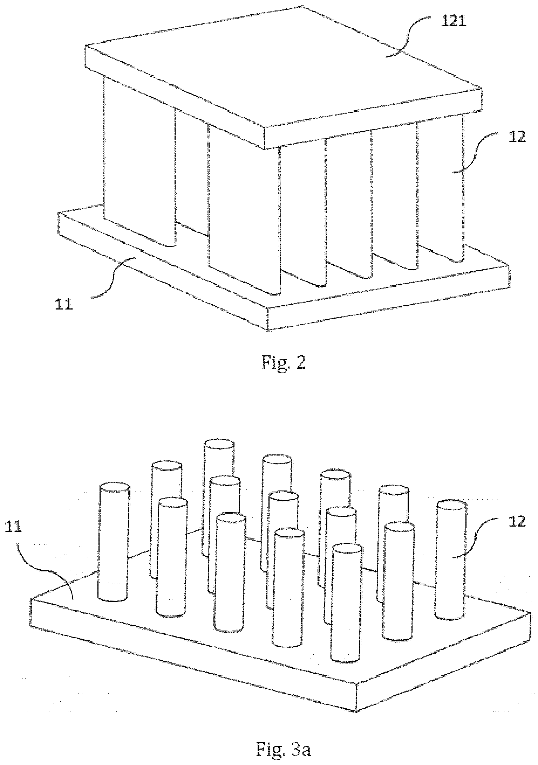

As shown in figures 2a-2b, the condenser part 12 further comprises a condensation top plate 121, a planar condensation chamber or a curved condensation chamber is formed in the condensation top plate 121, the part of condensation chamber in the condensation top plate 121 is communicated with the part of condensation chamber in the condensation support plates, and the whole condenser part 12 is in a comb shape. The phase-change heat exchange medium 20 absorbs heat in the evaporation chamber of the evaporator part 11, heat is dissipated through the condensation support plates and the condensation top plate 121 of the condenser part 12, and the phase-change heat exchange medium 20 circularly flows in the evaporation chamber of the evaporator part 11 and the condensation chamber in the condensation support plates and the condensation top plate 121 so as to dissipate heat of the heat source 30. The condensation top plate 121 may be integrally formed with the condensation support plates. The evaporator part 11 and the condenser part 12 of the phase-change assembly are also preferably integrally formed.

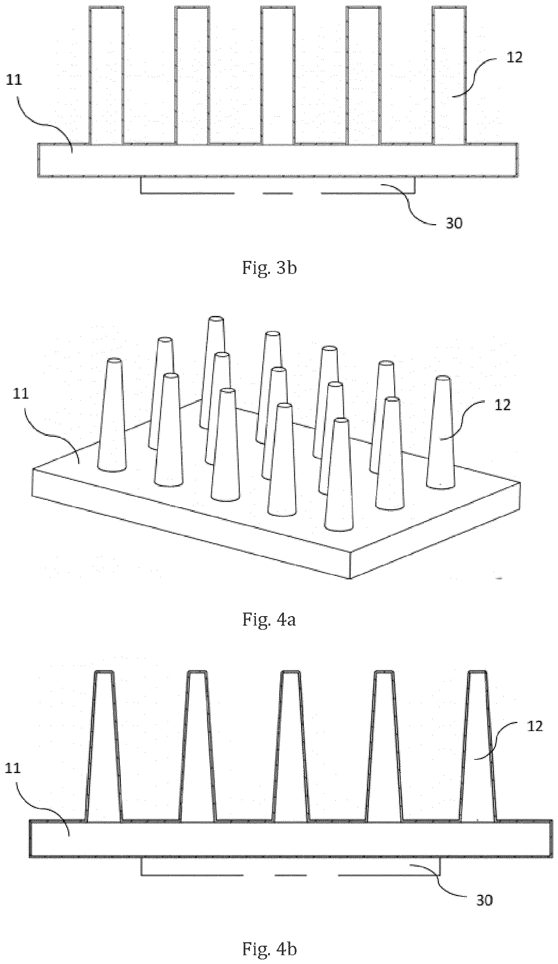

As shown in Figures 3a-3b, in this embodiment, the condensation support plates in the condenser part 12 take other forms, that is, the condenser part 12 comprises a plurality of cylindrical condensation branch pipes, and the condensation chamber comprises a cylindrical chamber correspondingly arranged inside each of the condensation branch pipes. As shown in Figures 4a-4b, the condenser part 12 can also comprise a plurality of condensation conical pipes, and the condensation chamber comprises a conical chamber correspondingly arranged inside each of the condensation conical pipes.

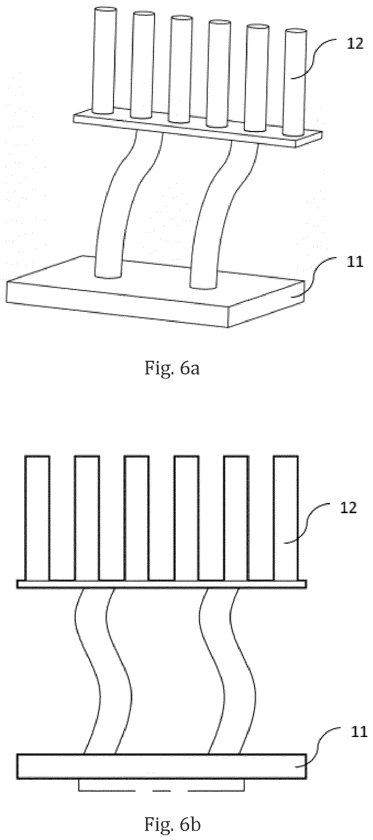

As shown in Figures 5a, 5b, 6a and 6b, the condensation chamber of the condenser part 12 is not directly connected with the evaporator part 11, and the condensation chamber of the condenser part 12 is connected to the evaporator part 11 through a pipeline, so that the condenser part 12 can be reasonably arranged according to the internal structure of the system of the heat source 30.

Therefore, the evaporator part 11 and the condenser part 12 of the phase-change assembly are directly communicated, the evaporator part 11 at one end of the phase-change assembly is directly communicated with the condenser part 12 at the other end of the phase-change assembly, and in the evaporation and condensation process of the phase-change heat exchange medium 20 in the phase-change assembly, horizontal and vertical three-dimensional diffusion of heat from one end of the phase-change assembly to the other end of the phase-change assembly can be achieved, and the temperature uniformity of the inner chamber of the whole phase-change assembly, especially of the condensation chamber in the condenser part 12, is improved.

The evaporator part 11 is in direct contact with the heat source 30, that is, the surface of the evaporator part 11 (the outer surface of the evaporation chamber) is in direct contact with the heat source 30, and the surface of the evaporator part 11 directly replaces a substrate of an existing heat dissipation device, so that the heat transfer efficiency between the heat source 30 and the evaporator part 11 is improved. The evaporator part 11 is preferably a planar plate-shaped body with a chamber inside, one side of the evaporator part 11 is provided with a contact heat absorption surface, the heat source 30 is provided with a planar heat source surface, and the contact heat absorption surface of the evaporator part 11 is in contact with the heat source surface of the heat source 30.

The area of the heat source surface of the heat source 30 is smaller than the area of the contact heat absorption surface of the evaporator part 11 of the phase-change assembly, and the internal phase-change heat exchange medium 20 can rapidly transfer heat from the heat source 30 to the evaporator part 11 of the phase-change assembly in two-dimensional directions through phase-change flow, so that the temperature in the evaporation chamber of the phase-change assembly can be ensured to be uniform. The vaporized phase-change heat exchange medium 20 enters the condensation support plates and flows in a third direction which is perpendicular to the evaporator part 11 having a planar plate-shaped body, i.e., perpendicular to the two-dimensional heat dissipation directions inside the evaporator part 11.

And a plurality of ribs, bumps or fins are arranged inside the evaporator part 11 and/or the condenser part 12 so as to improve the pressure bearing capability.

The phase-change assembly and the cooling fins can be made of copper, aluminum, copper alloy, aluminum alloy, magnesium alloy or stainless steel materials, for example, the phase-change assembly and the cooling fins are made of copper or aluminum materials, and the phase-change assembly and the cooling fins are preferably connected by brazing so as to reduce the contact thermal resistance between the phase-change assembly and the cooling fins. The temperature difference between the cooling fins and the heat source 30 is thereby reduced. After the heat source 30 (such as a power device CPU) and the phase-change heat dissipation device 10 (such as an evaporator part 11 thereof) are in contact connection, low-temperature tin soldering is applied to avoid gaps.

The cooling fins and the outer walls of the condensation supporting plates are welded together, the pressure bearing capability of the condensation support plates is improved, when the heat dissipation device works, the internal working pressure of the condenser part 12 and the evaporator part 11 can be increased, and if the internal working pressure is increased to be higher than 1MPa, an interwoven structure formed by welding the cooling fins and the condensation support plates can ensure that the condenser part 12 is able to bear the strength required by working. The condenser part 12 does not deform, and normal work of the heat dissipation device is guaranteed.

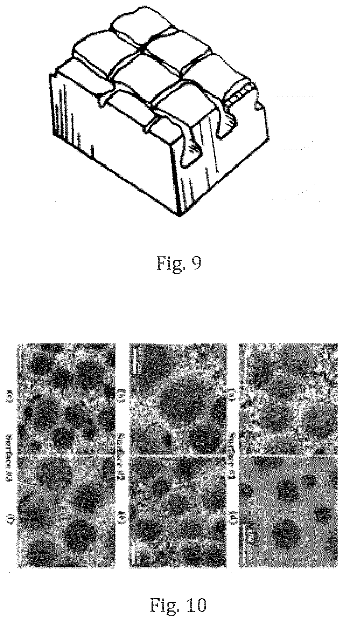

As shown in FIGS. 9-10, other heat exchange enhancement structures can be used instead of the cooling fins, and the heat exchange enhancement structures can be protrusions or channels formed on the outer surface of the condenser part 12 or the evaporator part 11 (FIG. 9), or can be porous structures formed on the surface of the condenser part 12 or the evaporator part 11 in a sintered manner (FIG. 10). By means of the heat exchange enhancement structure, the phase-change heat exchange medium 20 can perform boiling heat exchange more efficiently, heat diffusion is more uniform and rapid, and heat transfer to the external environment is more efficient due to the increase of the heat exchange area, wherein the heat exchange enhancement structure can be selected according to the power density and the machining and manufacturing cost of the heat source 30.

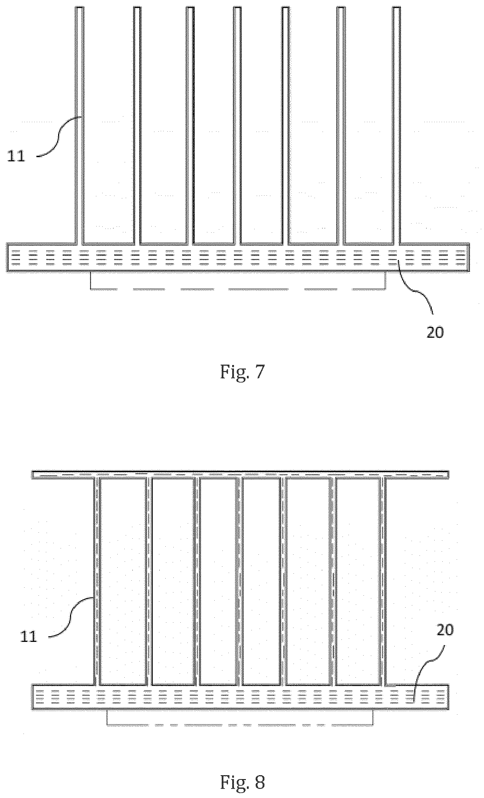

As shown in FIGS. 7-8, the circulation flow condition of the phase-change heat exchange medium 20 in the phase-change assembly is shown, the phase-change heat exchange medium 20 of the evaporator part 11 absorbs heat from the heat source 30 and then diffuses along a two-dimensional plane in the inner evaporation chamber of the evaporator part 11, and then the phase-change heat exchange medium 20 vaporizes and flows into the condensation support plates of the condenser part 12 perpendicular to the evaporator part 11. The phase-change heat exchange medium 20 that has flowed into the condensation support plates then flows into the condensation top plate 121, cooling fins are connected to the outer surfaces of the condensation support plates and the condensation top plate 121, and heat carried by the phase-change heat exchange medium 20 in the condensation support plates and the condensation top plate 121 is radiated outwards through the cooling fins, so that a more favorable heat dissipation effect and performance are obtained.

In the phase-change heat dissipation device, the evaporation chamber of the evaporator part is a planar or curved-surface-shaped thin-walled chamber, a capillary structure for enhancing boiling heat exchange is arranged in the evaporator part, the condenser part comprises a plurality of hollow condensation support plates or condensation branch pipes or condensation conical pipes, and structures for enhancing condensation heat exchange are arranged in the hollow support plates, hollow cylindrical pipes or hollow conical pipes, fins or ribs capable of increasing the condensation heat exchange area are connected to the exterior of the condenser part, so that the heat exchange performance is good.

In a non-working state, the environment temperature in the heat dissipation device is lower than the boiling point of the phase-change medium, the pressures at various sites of the internal chamber of the phase-change assembly are the same, and the internal pressure can be in a standard atmospheric pressure or negative pressure state. When the phase-change assembly is in a working state, the environment temperature is higher than the boiling point of the phase-change medium, the temperatures at various sites in the phase-change assembly are different, so that the pressures thereof are different, and the heat exchange in the phase-change assembly is based on the fact that the phase-change heat exchange medium 20 of the evaporator part 11 can be conveyed to the condenser part 12 by pressure difference induced by temperature difference in the phase-change assembly, so that heat exchange is realized. The conveying power for the phase-change heat exchange medium 20 from the evaporator part 11 to the condenser part 12 is derived from the pressure difference of the phase-change heat exchange medium 20 at different temperatures. Thus, the greater the pressure difference, the greater the ability to transport the medium. The transport capability of the phase-change assembly from the evaporator part 11 to the condenser part 12 is mainly determined by the pressure difference of the phase-change heat exchange medium 20 between the evaporator part 11 and the condenser part 12, the latent heat of vaporization of the phase-change heat exchange medium 20, and the density of the phase-change heat exchange medium 20.

In the prior art, commonly used phase-change heat exchange medium 20 include water, methanol, ethanol, and acetone, and these existing phase-change heat exchange media 20 are in a negative or micro-positive pressure state in operation.

By adopting the above phase-change heat exchange medium 20, the working pressure is in a negative pressure or micro-positive pressure state, namely the air pressure is less than 0.15 MPa. At present, the heating power of electronic devices is larger and larger, the heating power of a common CPU or GPU is larger than 200 W, and the power density is larger than 60000 J/m²·s. And when the surface temperature of the heat dissipation device is 60 °C, for a ϕ6mm*150mm copper-water heat pipe, the maximum transmission capacity of the temperature of the condenser part 12 is only 35W. Only four heat pipes can be arranged in the 45mm*69mm space of a common CPU, the maximum heat transfer capacity by using the copper-water heat pipes is only about 140W, residual heat needs to be conducted through the bottom of the heat dissipation device, and although ethanol, methanol and acetone adopted as the phase-change heat exchange medium 20 can increase the pressure difference and increase the transmitted volume flow, however, the latent heat of vaporization of deionized water is much higher than those of ethanol, methanol, acetone and the like when the volume flow thereof are equal, and therefore the heat transfer capacity of deionized water is stronger than those of ethanol, methanol, acetone and the like when the heat flux density is low and the temperature difference is the same. However, with the increase of heat flux density and the limitation of the size of a phase-change heat dissipation device, the heat transfer capacity of the traditional copper-water heat pipes is not enough to meet the requirement of high-power heat dissipation of electronic devices.

For a heat source 30 with a size of 42mm*69mm, the power of the heat source 30 adopts frequency conversion regulation, the condenser part 12 adopts liquid cooling, the amount of liquid is provided by a liquid cooling test device, the liquid inlet temperature is constant at 35°C, the temperature of the heat source 30 is guaranteed to be controlled at 40°C, different phase-change heat exchange media 20 are used, the working pressures and the heating powers inside the phase-change assembly are tested, and the test results are shown in Table 1:

The test results of heat flux densities of different phase-change heat exchange media 20 are as follows:

**Table 1**

| Name of the medium | Saturation Temperature (°C) | Saturation Pressure (MPa) | Boiling Heat Flow Density (W/cm²) |
|---|---|---|---|
| Water | 40 | 0.007381 | 16.5 |
| R142b | 40 | 0.522 | 26.3 |
| R124 | 40 | 0.322 | 22.3 |
| R1234Ze(E) | 40 | 0.7665 | 35.8 |
| R134a | 40 | 1.0166 | 36.5 |
| R1234Ze(Z) | 40 | 0.4918 | 24.8 |
| R1233Zd(E) | 40 | 0.21548 | 20.5 |
| R600a | 40 | 0.5312 | 23.1 |
| RC318 | 40 | 0.495 | 23.1 |
| RE245cb2 | 40 | 0.3325 | 21.6 |

As for each heat exchange medium, R134a is tetrafluoroethane (CF₃CH₂F), R114 is dichlorotetrafluoroethane (CCIF₂CCIF₂), R124 is tetrafluoromonochloroethane (CHCIFCF₃), R125 is pentafluoroethane (CHF₂CF₃), R1233Zd (E) or R1234Ze (Z) or R1234Ze (E) refers to trans-monochlorotrifluoropropene (CF₃CH=CHCl), R600a is isobutane (CH(CH₃)₃), RC318 is octafluorocyclobutane (cyclo-C₄F₈), R245fa or R245ca refers to pentafluoropropane (CHF₂CF₂CH₂F), R32 is trifluoromethane (CH₂F₂), and R22 is monochlorodifluoromethane (CHCIF₂).

### Example 1:

For a heat source 30 with a size of 30mm*45mm, the power of the heat source 30 adopts frequency conversion regulation, the condenser part 12 is air-cooled, the air volume is provided by a test wind tunnel, the inlet air temperature is 25°C, the outlet air temperature is 50°C, the temperature of the heat source 30 is guaranteed to be controlled at 60°C, different phase-change heat exchange media 20 are used, the working pressures and the heating powers inside the phase-change assembly are tested, and the test results are shown in Table 2:

**Table 2**

| Phase-change medium | Heat source temperature (°C) | Heat source power (W) | Phase-Change Assembly Internal Pressure (MPa) | Inlet air Temperature (°C) | Outlet air temperature (°C) | Air volume (m³/h) |
|---|---|---|---|---|---|---|
| R142b | 60 | 305.9 | 0.52 | 25 | 50 | 64.7 |
| R114 | 60 | 210 | 0.33 | 25 | 50 | 44.57 |
| R124 | 60 | 297 | 0.59 | 25 | 50 | 63 |
| R134a | 60 | 333 | 0.70 | 25 | 50 | 70.7 |
| RE245cb2 | 60 | 236 | 0.33 | 25 | 50 | 50 |

As can be seen from the data of Table 2, in the present invention, the transmission capacity of the phase-change assembly is greatly increased due to the increase of pressure difference in the phase-change assembly by using a phase-change heat exchange medium 20 having a boiling point of less than 30°C at the standard atmospheric pressure, and the transmission capacity is significantly improved (much greater than 200 W) for a CPU of size 45mm*69mm and a heat dissipation device of the same volume by using a phase-change heat exchange medium 20 such as R134a, R142b, R114, R124, R1233Zd(E), R1234Ze(Z), R1234Ze(E), R600a, RC318, RE245cb2.

Therefore, by arranging the phase-change heat exchange medium, selected from R134a, R142b, R114, R124, R1233Zd(E), R1234Ze(Z), R1234Ze(E), R600a, RC318, RE245cb2 and the like or a combination thereof, in the phase-change assembly, when the phase-change heat dissipation device is in a working state, the air pressure inside the phase-change assembly can be made higher than 0.15 MPa, and the above phase-change heat exchange medium can be purchased on the market.

According to test data, the heat transfer capacity of the phase-change assembly is in positive correlation with the internal air pressure of the phase-change assembly, and the larger the pressure is, the larger the heat exchange power is.

The present invention can be applied to power electronic devices such as a chip, a resistor, a capacitor, an inductor, a storage medium, a light source and a battery pack for heat dissipation.

It can be understood that, the present invention is described with reference to some embodiments, and as known by a person skilled in the art, without departing from the working theory and scope of the present invention, various changes and equivalent modifications can be made to these features and embodiments. And, under the guidance of the present invention, these features and embodiments can be modified to adapt to specific circumstances and materials without departing from the working theory and scope of the present invention. Therefore, the present invention is not to be limited by the particular embodiments disclosed herein, and all embodiments falling within the scope of the claims of the present application are intended to be encompassed by the protection scope of the present invention.

## Claims

1. A phase-change heat dissipation device, comprising a phase-change assembly internally provided with a phase-change heat exchange medium, **characterized in that** the phase-change heat exchange medium provided in the phase-change assembly is configured such that, in an operating state of the phase-change heat dissipation device, an air pressure within the phase-change assembly is greater than 0.15 MPa.

2. The phase-change heat dissipation device according to claim 1, **characterized in that** the phase-change heat exchange medium provided in the phase-change assembly is any one or more of R134a, R142b, R114, R124, R1233Zd(E), R1234Ze(Z), R1234Ze(E), R600a, RC318, RE245cb2, R22, R32, R407C and R410A.

3. The phase-change heat dissipation device according to claim 1, **characterized in that** the phase-change assembly comprises an evaporator part and a condenser part, an evaporation chamber is formed in the evaporator part, a condensation chamber is formed in the condenser part, the evaporation chamber is communicated with the condensation chamber, and the phase-change heat exchange medium in the evaporation chamber is configured to absorb heat from a heat source and transfer the heat to the condensation chamber, and the condensation chamber is configured to radiate heat outwards, so as to cool the heat source.

4. The phase-change heat dissipation device according to claim 3, **characterized in that** the evaporation chamber is a planar or curved chamber.

5. The phase-change heat dissipation device according to claim 3, **characterized in that** the condenser part comprises a plurality of condensation support plates, and the condensation chamber comprises a planar chamber correspondingly arranged inside each of the condensation support plates; or the condenser part comprises a plurality of condensation branch pipes, and the condensation chamber comprises a cylindrical chamber correspondingly arranged inside each of the condensation branch pipes; or the condenser part comprises a plurality of condensation conical pipes, and the condensation chamber comprises a conical chamber correspondingly arranged inside each of the condensation conical pipes.

6. The phase-change heat dissipation device according to claim 3, **characterized in that** the condenser part is connected to the evaporator part directly or through a pipeline.

7. The phase-change heat dissipation device according to claim 3, **characterized in that** the inner wall of the condenser part is provided with a condensation enhancement structure, and the outer wall of the condenser part is provided with fins or ribs for increasing the condensation area.

8. The phase-change heat dissipation device according to claim 3, **characterized in that** a plurality of ribs, bumps or fins are arranged inside the evaporator part and the condenser part to increase the pressure bearing capability.

9. The phase-change heat dissipation device according to claim 3, **characterized in that** the outer wall of the evaporator part is in contact with the heat source.

10. The phase-change heat dissipation device according to claim 9, **characterized in that** the outer surface of the evaporator part is provided with a contact heat absorption surface, the heat source is provided with a heat source surface, the contact heat absorption surface of the evaporator part is in contact with the heat source surface of the heat source, and both the heat source surface and the contact heat absorption surface are planar.
